# EUROPÄISCHE PATENTSCHRIFT

(11) **EP 2 449 863 B1**
(45) Veröffentlichungstag und Bekanntmachung des Hinweises auf die Patenterteilung: **28.08.2019**
(21) Anmeldenummer: 10732837.9
(22) Anmeldetag: 25.06.2010
(51) Int. Cl.: H05K 1/02, H05K 1/03, H05K 3/34

(54) **MEHRLAGIGE LEITERPLATTE, INSBESONDERE FLAMMBESTÄNDIGE UND/ODER RAUCHGAS UNTERDRÜCKENDE MEHRLAGIGE LEITERPLATTE**
MULTILAYER CONDUCTIVE PLATE, IN PARTICULAR FLAME RETARDANT AND/OR SMOKE REDUCING MULTIPLAYER CONDUCTIVE PLATE
PLAQUE CONDUCTRICE MULTICOUCHE, EN PARTICULIER PLAQUE CONDUCTRICE MULTICOUCHE RESISTANTE AU FEU ET/OU ATTÉNUANT LES FUMÉES

(30) Priorität: 30.06.2009 AT 40909 U
(43) Veröffentlichungstag der Anmeldung: 09.05.2012
(73) Patentinhaber: AT & S Austria Technologie & Systemtechnik Aktiengesellschaft, 8700 Leoben-Hinterberg (AT)
(72) Erfinder: FROSCH, Ronald, A-8330 Feldbach (AT); RIEDLER, Manfred, A-8062 Kumberg (AT)
(74) Vertreter: Miksovsky, Alexander
(86) Internationale Anmeldenummer: PCT/AT2010/000233
(87) Internationale Veröffentlichungsnummer: WO 2011/000009

(56) Entgegenhaltungen:
- WO-A1-2007/059152
- GB-A- 2 259 812
- US-A- 6 132 853
- US-A1- 2003 029 830
- US-A1- 2008 266 018
- MCMAHON R R ET AL: "DESIGNING FOR MANUFACTURABILITY OVERVIEW", PRINTED CIRCUIT DE, MILLER FREEMAN, SAN FRANCISCO, CA, US, vol. 3, no. 4, 1 April 1986 (1986-04-01), pages 3-06, XP008013033, ISSN: 0884-9862

## Beschreibung

Die vorliegende Erfindung bezieht sich auf eine mehrlagige Leiterplatte, insbesondere flammbeständige und/oder Rauchgas unterdrückende mehrlagige Leiterplatte, welche aus einer Mehrzahl von miteinander verbundenen Lagen aus nicht brennbarem, leitendem Material und Lagen aus nicht leitendem Material besteht, wobei jeweils zwei Lagen aus einem leitenden Material durch wenigstens eine Lage aus einem nicht leitenden Material getrennt sind.

Eine mehrlagige Leiterplatte der obigen Art ist beispielsweise der US 2008/0266018 A1 zu entnehmen, wobei darauf abgezielt wird, eine Beeinflussung zwischen Signalen einer analogen Schaltung und einer digitalen Schaltung bei einer derartigen Leiterplatte zu vermeiden bzw. zumindest zu reduzieren.

Ein ähnliches mehrlagiges Substrat ist beispielsweise der US 2003/0029830 A1 zu entnehmen, wobei auf die Bereitstellung mehrlagiger Substrate mit verringerter Dicke bei Aufrechterhaltung einer ausreichenden, insbesondere mechanischen Festigkeit bei einer Handhabung abgezielt wird.

Darüber hinaus ist aus der WO 2007/059152 ein Kleber für ein insbesondere mehrlagiges Leiterplattenmaterial bekannt, wobei auf verbesserte Eigenschaften insbesondere bei einem Einsatz unter Bedingungen hoher bzw. erhöhter Temperatur und Feuchtigkeit abgezielt wird.

Aus MCMAHON R R et al; 1. April 1986; "Designing for manufacturability Overview"; Printed Circuit Design; Miller Freeman; San Francisco; USA; Vol. 3: Nr. 4; S. 3-06; WP008013033; ISSN: 0884-9862 ist die Verwendung von Lötmasken und deren Funktion im Zusammenhang mit der Herstellung von Leiterplatten bekannt.

Abhängig von den Verwendungs- bzw. Einsatzzwecken von mehrlagigen Leiterplatten müssen derartige Leiterplatten nicht nur entsprechende mechanische und insbesondere elektrische Überprüfungs- und/oder Sicherheitsanforderungen erfüllen. Insbesondere bei einem Einsatz in speziellen Umgebungen oder für spezielle Zwecke werden für derartige Leiterplatten auch üblicherweise zusätzliche Tests vorgeschrieben. So ist beispielsweise bei einem Einsatz von Materialien in der Luftfahrtindustrie unter anderem ein sogenannter "Smoke Density Test" vorgeschrieben, welchem im wesentlichen sämtliche, in der Luftfahrtindustrie zum Einsatz gelangende Materialien unterworfen werden, wobei gegebenenfalls in Abhängigkeit vom Einsatzzweck unterschiedliche Erfordernisse bei einem derartigen Test erfüllt werden müssen.

Für eine Verwendung von Leiterplatten in der Luftfahrtindustrie im Zusammenhang mit dem oben genannten Smoke Density Test ist beispielsweise vorgeschrieben, dass eine Rauchgasentwicklung durch eine derartige Leiterplatte in einem vorgegebenen Testvolumen bei von außen anliegenden erhöhten Temperaturen und/oder unmittelbar einem Aussetzen an eine Flamme über einen Zeitraum von 240 s eine maximale, spezifische, optische Dichte unter 200 ergeben muss. Bei einem derartigen Test wird jeweils eine Probe mit Abmessungen von beispielsweise 75 mm x 75 mm in einem entsprechenden Halter aufgenommen, wobei nach einer Abschirmung an vorgegebenen Seitenflächen im Wesentlichen eine Oberfläche mit dem genannten Ausmaß entweder einer erhöhten Temperatur oder unmittelbar einer definierten Einwirkung einer Flamme unterworfen ist.

Problematisch bei bisher bekannten Konstruktionen bzw. Strukturen von mehrlagigen Leiterplatten ist insbesondere der vergleichsweise hohe Anteil von üblicherweise leicht brennbaren, nicht leitenden Materialien, aus welchen eine derartige mehrlagige Leiterplatte üblicherweise aufgebaut ist.

Die vorliegende Erfindung zielt daher darauf ab, eine mehrlagige Leiterplatte der eingangs genannten Art, insbesondere eine flammbeständige und/oder Rauchgas unterdrückende mehrlagige Leiterplatte zur Verfügung zu stellen, welche für spezielle Einsatzzwecke geeignet ist und insbesondere fähig ist, Bedingungen des oben genannten Smoke Density Tests zuverlässig einzuhalten, um derart einen Einsatz derartiger mehrlagiger Leiterplatten beispielsweise auch in der Luftfahrtindustrie zu ermöglichen.

Zur Lösung dieser Aufgaben wird eine mehrlagige Leiterplatte, insbesondere flammbeständige und/oder Rauchgas unterdrückende mehrlagige Leiterplatte zur Verfügung gestellt, welche aus einer Mehrzahl von miteinander verbundenen Lagen aus nicht brennbarem, leitendem Material und Lagen aus nicht leitendem Material besteht, wobei jeweils zwei Lagen aus einem leitenden Material durch wenigstens eine Lage aus einem nicht leitenden Material getrennt sind, wobei auf zum Äußeren gewandten Lagen aus dem nicht brennbaren, leitenden Material jeweils zusätzlich eine Lötmaske vorgesehen ist und die Dicke der Lagen aus nicht brennbarem, leitendem Material geringer als die Dicke der wenigstens einen Lage aus nicht leitendem Material ist, wobei - zur Erfüllung von Testanforderungen für eine Rauchgasentwicklung insbesondere in der Luftfahrtindustrie, wonach bei von außen anliegenden erhöhten Temperaturen und/oder einem unmittelbaren Aussetzen an eine Flamme über einen Zeitraum von 240 s eine maximale spezifische optische Dichte (Dm) unter 200 zu erzielen ist - die Leiterplatte in ihrem Inneren wenigstens zwei Lagen enthält, welche einen Oberflächenanteil von wenigstens 50 %, insbesondere wenigstens 70 % aus dem nicht brennbaren, leitenden Material aufweisen, die Leiterplatte an ihren zum Äußeren gewandten Oberflächen Lagen enthält, welche jeweils einen Oberflächenanteil von wenigstens 15 %, insbesondere wenigstens 40 % aus dem nicht brennbaren, leitenden Material aufweisen, die Lagen im Inneren der Leiterplatte aus dem nicht brennbaren, leitenden Material durch wenigstens eine Lage aus nicht leitendem Material, insbesondere einem Dielektrikum getrennt sind, welches eine Dicke von höchstens 250 µm, insbesondere höchstens 150 µm aufweist, und der Volumsanteil an Lagen aus dem nicht brennbaren, leitenden Material wenigstens 8 Vol.-%, insbesondere wenigstens 12 Vol.-% der mehrlagigen Leiterplatte beträgt.

Da die Leiterplatte in ihrem Inneren wenigstens zwei Lagen mit einem hohen Oberflächenanteil, bestehend aus dem nicht brennbaren, leitenden Material von wenigstens 50 %, insbesondere wenigstens 70 % aufweist, wird sichergestellt, dass sowohl bei einem Aussetzen an erhöhte Temperaturen als auch gegebenenfalls einem unmittelbaren Aussetzen an eine Flamme bzw. ein Feuer gegebenenfalls lediglich Teilbereiche einer derartigen Leiterplatte insbesondere unter Rauchentwicklung aufgrund der in einer derartigen mehrlagigen Leiterplatte üblicherweise enthaltenen nicht leitenden, harzartigen Materialien zerstört bzw. beschädigt werden, während insbesondere eine vollkommene Zerstörung der Leiterplatte über den erforderlichen Testzeitraum von beispielsweise 4 Minuten unter Reduzierung bzw. Minimierung einer Rauchentwicklung weitestgehend verhindert wird. Durch den hohen Oberflächenanteil von im Inneren der Leiterplatte angeordneten Lagen aus nicht brennbarem, leitendem und somit insbesondere metallischem Material wird sichergestellt, dass die Anforderungen im Hinblick auf eine entsprechend geringe Rauchentwicklung zuverlässig erfüllt werden können. Für eine weitere Verbesserung der Flammbeständigkeit, insbesondere der zum Äußeren gewandten Oberflächen wird bei der erfindungsgemäßen Leiterplatte darüber hinaus vorgeschlagen, dass auf den zum Äußeren gewandten Lagen aus dem nicht brennbaren, leitenden Material jeweils zusätzlich eine Lötmaske vorgesehen ist. Insbesondere zur Verringerung der Kosten der Herstellung einer erfindungsgemäßen mehrlagigen Leiterplatte wird darüber hinaus vorgeschlagen, dass die Dicke der Lagen aus nicht brennbarem, leitendem Material geringer als die Dicke der wenigstens einen Lage aus nicht leitendem Material ist.

Zur weiteren Verbesserung der Flammbeständigkeit und/oder Reduzierung von entstehendem Rauch bzw. Rauchgas wird darüber hinaus vorgeschlagen, dass die Leiterplatte an ihren zum Äußeren gewandten Oberflächen Lagen enthält, welche jeweils einen Oberflächenanteil von wenigstens 15 %, insbesondere wenigstens 40 % aus dem nicht brennbaren, leitenden Material aufweisen. Derartige Anteile bzw. Oberflächenanteile aus nicht brennbarem, leitendem Material an der zum Äußeren gewandten Oberfläche der mehrlagigen Leiterplatte verhindern insbesondere einen raschen Beginn einer Beschädigung bzw. Vernichtung einer erfindungsgemäßen Leiterplatte durch die auch zum Äußeren gewandten großflächigen Anteile aus nicht brennbarem, leitendem Material, um derart die Flammbeständigkeit und/oder Möglichkeit einer Unterdrückung bzw. Minimierung einer Rauchgasentwicklung weiter zu verbessern.

Zur Verbesserung der gewünschten Reduktion bzw. Minimierung des in einem Brandfall entstehenden Rauchs ist darüber hinaus vorgesehen, dass die Lagen im Inneren der Leiterplatte aus dem nicht brennbaren, leitenden Material durch wenigstens eine Lage aus nicht leitendem Material, insbesondere einem Dielektrikum getrennt sind, welches eine Dicke von höchstens 250 µm, insbesondere höchstens 150 µm aufweist. Durch eine derartige Begrenzung der maximalen Dicke der Lage(n) bzw. Schicht(en) aus nicht leitendem Material, insbesondere einem Dielektrikum, welches bei den üblicherweise bei der Herstellung von Leiterplatten eingesetzten Materialien, bestehend aus Harzen, Kunststoffen oder dgl., üblicherweise eine hohe Brennbarkeit und insbesondere Rauchentwicklung aufweist, wird sichergestellt, dass gleichzeitig mit dem Vorliegen von einen vergleichsweise großen Oberflächenanteil aufweisenden Lagen aus dem nicht brennbaren, leitenden Material die Anforderungen von derartigen zusätzlichen Tests für spezielle Einsatzzwecke erfüllt werden können.

Zur Erfüllung der Kriterien des eingangs genannten Smoke Density Tests unter Einsatz insbesondere von Lagen bzw. Schichten mit einem Oberflächenanteil an nicht brennbarem, leitendem Material entsprechender Größe ist weiters erfindungsgemäß vorgesehen, dass der Volumsanteil an Lagen aus dem nicht brennbaren, leitenden Material wenigstens 8 Vol.-%, insbesondere wenigstens 12 Vol.-% der mehrlagigen Leiterplatte beträgt.

Eine besonders gute Flammbeständigkeit bzw. Schutzwirkung der zum Äußeren gewandten Oberfläche einer erfindungsgemäßen, mehrlagigen Leiterplatte wird hierbei dadurch erzielt, dass der Oberflächenanteil des nicht brennbaren, leitenden Materials der zum Äußeren gewandten Lage größer als der Oberflächenanteil der Lötmaske ist, wie dies einer weiters bevorzugten Ausführungsform der erfindungsgemäßen Leiterplatte entspricht.

Um ein Durchbrennen der erfindungsgemäßen Leiterplatte bzw. ein einfaches Durchtreten von Flammen durch eine üblicherweise eine vergleichsweise geringe Dicke aufweisende Leiterplatte zu erschweren bzw. zu unterdrücken, wird gemäß einer weiters bevorzugten Ausführungsform vorgeschlagen, dass Teilbereiche aus nicht brennbarem, leitendem Material einzelner Lagen, welche jeweils durch wenigstens eine Lage aus nicht leitendem Material getrennt sind, in einer Draufsicht auf die mehrlagige Leiterplatte zueinander versetzt und/oder insbesondere einander wenigstens teilweise überlappend ausgebildet bzw. angeordnet sind. Durch eine derartig versetzte und/oder wenigstens teilweise überlappende Anordnung von Teilbereichen der einzelnen Lagen aus nicht brennbarem, leitendem Material wird die Widerstandsfähigkeit der erfindungsgemäßen Leiterplatte gegenüber einem Einwirken von Flammen auch auf tiefer gelegene Schichten bzw. Lagen der mehrlagigen Leiterplatte, insbesondere aus nicht leitendem und üblicherweise leicht bzw. leichter brennbarem Material weiter verbessert, da insbesondere einem Durchbrennen durch mehrere Lagen einer derartigen, mehrlagigen Leiterplatte ähnlich einer Kaminwirkung durch ein Vermeiden einer sich insbesondere über mehrere Lagen erstreckenden Durchtrittsöffnung entgegengewirkt wird.

Zur Erzielung der im Zusammenhang mit der Herstellung einer mehrlagigen Leiterplatte neben der erfindungsgemäß angestrebten Flammbeständigkeit und/oder Rauchgasunterdrückung erforderlichen, elektrischen Leitfähigkeit bei der Strukturierung einer derartigen mehrlagigen Leiterplatte wird gemäß einer weiters bevorzugten Ausführungsform vorgeschlagen, dass die Lage(n) aus dem nicht brennbaren, leitenden Material jeweils von einer Kupferschicht gebildet ist bzw. sind.

Neben der erfindungsgemäß vorgeschlagenen Anordnung von Lagen bzw. Schichten aus nicht brennbarem, leitendem Material mit einem entsprechend großen Oberflächenanteil zur Verbesserung bzw. Erhöhung der Flammbeständigkeit und/oder zur Reduzierung bzw. Unterdrückung der Rauchgasentwicklung wird erfindungsgemäß auch darauf abgezielt, die Entflammbarkeit bzw. Brennbarkeit als auch Rauchgasentwicklungseigenschaft von üblicherweise bei der Herstellung einer mehrlagigen Leiterplatte verwendeten, nicht leitenden Materialien, insbesondere Dielektrika entsprechend zu verbessern. In diesem Zusammenhang wird gemäß einer weiters bevorzugten Ausführungsform vorgeschlagen, dass der (den) Lage(n) aus dem nicht leitenden Material flammbeständige und/oder Rauchgas unterdrückende Füllstoffe, wie beispielsweise Al(OH)₃,SiO₂ und dgl. zugesetzt sind und/oder eine Lage aus nicht leitendem Material durch eine flammhemmende Schicht, beispielsweise eine Polyimidschicht abgedeckt ist. Durch Verwendung derartiger Füllstoffe bzw. Zusätze und/oder durch Abdeckung durch flammenhemmende Materialien kann die Flammbeständigkeit der erfindungsgemäßen mehrlagigen Leiterplatte weiter verbessert werden, wodurch die Anforderungen entsprechend einfacher und zuverlässiger, beispielsweise in dem eingangs genannten Smoke Density Test erfüllt werden können. Somit kann ein derartiger Testerfolg auch mit mehrlagigen Leiterplatten erhalten werden, welche aufgrund der zunehmenden Komplexheit der Strukturen derartiger mehrlagiger Leiterplatten mit einem entsprechend höheren Anteil von Lagen bzw. Schichten und insbesondere Lagen aus nicht leitenden Materialien versehen bzw. ausgebildet sind, welche zwischen aufeinanderfolgenden Lagen aus leitendem Material eingesetzt werden müssen.

Zur Bereitstellung von einen Test für spezielle Einsatzzwecke, beispielsweise den eingangs genannten Smoke Density Test zuverlässig erfüllenden mehrlagigen Leiterplatten wird gemäß einer weiters bevorzugten Ausführungsform vorgeschlagen, daß die Anzahl der Lagen aus nicht leitendem Material weniger als 7, insbesondere weniger als 5 beträgt.

Neben der Tatsache, dass, wie oben ausgeführt, durch die erfindungsgemäß vorgeschlagenen Maßnahmen der Verwendung von Schichten bzw. Lagen aus nicht brennbarem, leitendem Material mit einem vergleichsweise großen Oberflächenanteil als auch die entsprechende Verwendung von zwischenliegenden Schichten bzw. Lagen aus nicht leitendem Material die Bedingungen des eingangs genannten Smoke Density Tests zuverlässig erfüllt werden können, gelingt es erfindungsgemäß, mehrlagige Leiterplatten auch mit gegenüber bekannten mehrlagigen Leiterplatten vergleichsweise großer Dicke zur Verfügung zu stellen. Im Zusammenhang mit der vorliegenden Erfindung wird hiebei vorgeschlagen, dass die Gesamtdicke der mehrlagigen Leiterplatte höchstens 1,25 mm, insbesondere maximal 1 mm beträgt, wie dies einer weiters bevorzugten Ausführungsform der erfindungsgemäßen Leiterplatte entspricht.

Die Erfindung wird nachfolgend anhand von in der beiliegenden Zeichnung schematisch dargestellten Ausführungsbeispielen näher erläutert, wobei zusätzlich eine Vielzahl von Ausführungsbeispielen sowie Vergleichsbeispielen betreffend den Aufbau bzw. die Struktur von erfindungsgemäßen mehrlagigen Leiterplatten angegeben ist.
Fig. 1 zeigt einen schematischen Teilschnitt durch eine erste Ausführungsform einer erfindungsgemäßen mehrlagigen Leiterplatte; und
Fig. 2 zeigt in einer zu Fig. 1 ähnlichen Darstellung ebenfalls einen schematischen Schnitt durch eine abgewandelte Ausführungsform einer erfindungsgemäßen, mehrlagigen Leiterplatte mit einer erhöhten Anzahl von Schichten bzw. Lagen.

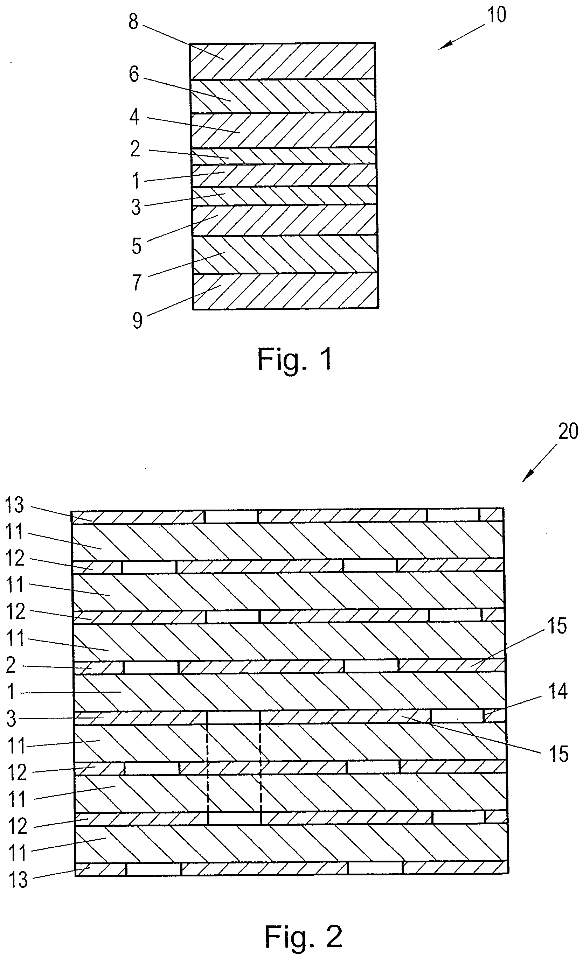

Bei dem schematischen Schnitt durch eine mehrlagige Leiterplatte einer ersten Ausführungsform gemäß Fig. 1 ist ersichtlich, daß an einen Core bzw. Kern 1, welcher bei der Herstellung mehrlagiger Leiterplatten beispielsweise aus einem gehärteten bzw. ausgehärteten Harzmaterial besteht, Lagen 2, 3 aus einem nicht brennbaren, leitenden Material anschließen, wobei bei der Darstellung gemäß Fig. 1 diese Lagen 2, 3 im wesentlichen als vollflächig dargestellt sind.

Anschließend an die Lagen 2, 3 aus nicht brennbarem, leitendem Material sind Lagen 4, 5 aus einem nicht leitenden Material, insbesondere Dielektrikum vorgesehen.

An den zum Äußeren gewandten Oberflächen der allgemein mit 10 bezeichneten mehrlagigen Leiterplatte schließen an die Lagen 4, 5 wiederum Lagen bzw. Schichten 6, 7 aus einem nicht brennbaren, leitenden Material an, wobei eine, üblicherweise bei derartigen Leiterplatten zumindest für die außenliegenden Lagen 6, 7 aus leitendem Material vorgesehene Strukturierung bei der schematischen Darstellung gemäß Fig. 1 nicht näher gezeigt ist.

Darüber hinaus sind zusätzliche Schichten 8, 9 als Lötmaske vorgesehen, wobei insgesamt der Oberflächenanteil der Lötmasken 8, 9 bei der fertiggestellten Leiterplatte den Oberflächenanteil der unmittelbar darunterliegenden bzw. anschließenden Schichten bzw. Lagen 6, 7 aus nicht brennbarem, leitendem Material nicht übersteigt.

Zu der Darstellung gemäß Fig. 1 wird darauf verwiesen, daß die Dicken der einzelnen Schichten bzw. Lagen 1 bis 9 nicht maßstabsgemäß dargestellt sind, wobei Beispiele für derartige Dicken einzelner Schichten bzw. Lagen insbesondere aus den Beispielen gemäß Tabelle 1 ersichtlich sind.

Weiters sind bei den Darstellungen gemäß Fig. 1 und 2 keinerlei weitere Komponenten, Bauteile oder dgl. einer derartigen mehrlagigen Leiterplatte zur Vereinfachung der Darstellung dargestellt.

Bei der in Fig. 2 schematisch dargestellten abgewandelten Ausführungsform einer mehrlagigen Leiterplatte 20 ist wiederum ein Kern bzw. Core 1 ersichtlich, an welchen unmittelbar Schichten bzw. Lagen 2, 3 aus einem nicht brennbaren, leitenden Material, insbesondere Kupfer anschließen.

Bei dem in Fig. 2 dargestellten Aufbau einer mehrlagigen Leiterplatte 20 ist darüber hinaus ersichtlich, daß eine Mehrzahl von jeweils mit 11 bezeichneten Lagen bzw. Schichten aus einem nicht leitenden Material, insbesondere Dielektrikum, wie beispielsweise PP (Polypropylen) vorgesehen ist bzw. anschließt, zwischen welchen jeweils mit 12 bezeichnete Lagen aus nicht brennbarem, leitendem Material, insbesondere Kupfer vorgesehen sind. Darüber hinaus sind an den zum Äußeren gewandten Oberflächen der mehrlagigen Leiterplatte 20 wiederum Schichten bzw. Lagen 13 aus nicht brennbarem, leitendem Material, insbesondere Kupfer vorgesehen.

Auch zur Darstellung gemäß Fig. 2 wird festgehalten, daß die Dicken der einzelnen Schichten bzw. Lagen dieser beispielhaften Ausführungsform nicht maßstabsgetreu dargestellt sind. Betreffend mögliche Ausführungsformen bzw. Dicken und Anordnungen derartiger Lagen wird wiederum auf die Beispiele von Tabelle 1 verwiesen.

Bei der Darstellung gemäß Fig. 2 ist darüber hinaus ersichtlich, daß die Schichten bzw. Lagen 2, 3 sowie 12 und 13, welche jeweils aus einem nicht brennbaren, leitenden Material, insbesondere Kupfer bestehen, mit einer Mehrzahl von Durchbrechungen 14 ausgebildet sind, wobei dazwischen liegende Teilbereiche 15 zwischen den einzelnen Durchbrechungen jeweils zueinander versetzt sind bzw. Durchbrechungen 14 einer Schicht bzw. Lage von entsprechenden Bereichen bzw. Teilbereichen 15 aus nicht brennbarem, leitendem Material überlappt bzw. übergriffen sind. Derart wird insbesondere ein einfaches Durchbrennen der Lagen 11 sowie des Kerns 1 aus nicht leitendem Material, welches üblicherweise leicht brennbar ist, verhindert, so daß die Flammbeständigkeit der mehrlagigen Leiterplatte 20 bzw. deren Fähigkeit, eine Rauchgasentwicklung zu verzögern bzw. zu unterdrücken, entsprechend verbessert wird.

Wie dies anhand der in Tabelle 1 im Detail angeführten Ausführungsbeispiele näher ersichtlich ist, ist wenigstens teilweise den Lagen 4, 5 oder 11 aus nicht leitendem Material ein Füllstoff zur Verbesserung der Flammbeständigkeit bzw. zur Rauchgasunterdrückung beigesetzt. Alternativ oder zusätzlich können zusätzliche Lagen aus einem flammbeständigen Material, insbesondere entsprechend verringerter Dicke, wie beispielsweise Polyimid (PI) vorgesehen sein.

Weiters können im Zusammenhang mit der Darstellung von Fig. 2 wenigstens einzelne Lagen 12 aus nicht brennbarem, leitendem Material weggelassen bzw. entfernt sein, wie dies beispielsweise in Beispiel 5 und 11 angeführt ist.

Zu den nachfolgenden Tabellen 1 und 2 wird einleitend angemerkt, daß in Tabelle 1 eine Vielzahl von unterschiedlichen Strukturen von der mehrlagigen Leiterplatte 10 bzw. 20 insbesondere auf Basis der schematischen Darstellungen von Fig. 1 und Fig. 2 angegeben ist. Die einzelnen Beispiele 1 bis 17 unterscheiden sich insbesondere durch die Anzahl der jeweils verwendeten Schichten bzw. Lagen sowohl aus leitendem, nicht brennbarem Material als auch aus nicht leitendem Material, insbesondere Dielektrikum. Darüber hinaus sind unterschiedliche Aufbauten bzw. Strukturen mit insbesondere jeweils unterschiedlichen Flächenanteilen bzw. Oberflächenanteilen sowohl der im Inneren enthaltenen Schichten bzw. Lagen aus nicht brennbarem, leitendem Material als auch insbesondere der zur äußeren Oberfläche gewandten Schichten bzw. Lagen ersichtlich.

Darüber hinaus sind in Tabelle 2 mehrere Vergleichsbeispiele angeführt, wobei für jeweils unterschiedliche Strukturen bzw. Aufbauten wiederum jeweils eine Mehrzahl von Schichten bzw. Lagen von mehrlagigen Leiterplatten insbesondere unter Verwendung von Materialien für die einzelnen Schichten bzw. Lagen angegeben ist, welche denjenigen in den Beispielen 1 bis 17 verwendeten Materialien entsprechen, wobei jedoch die Anforderungen für den eingangs erwähnten Smoke Density Test von diesen Vergleichsbeispielen nicht erfüllt werden.

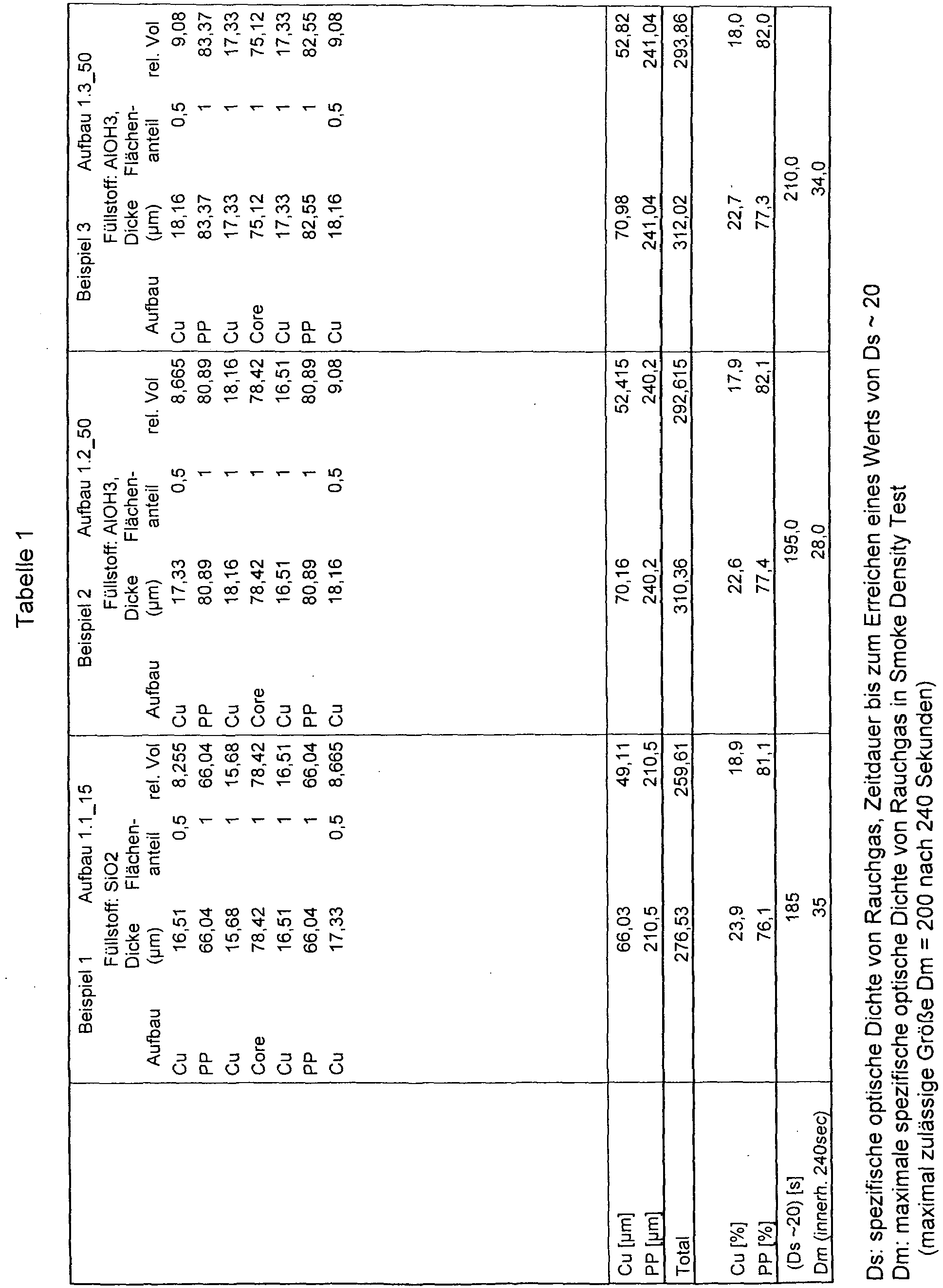

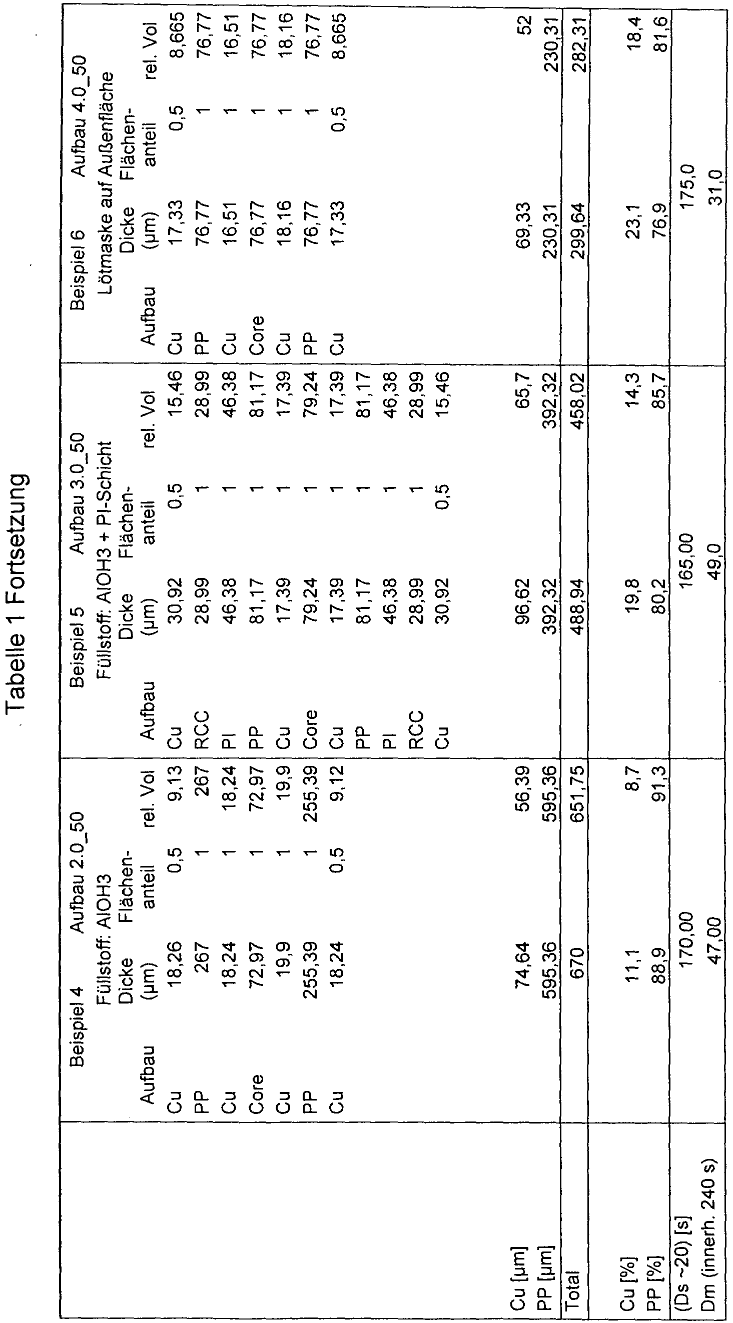

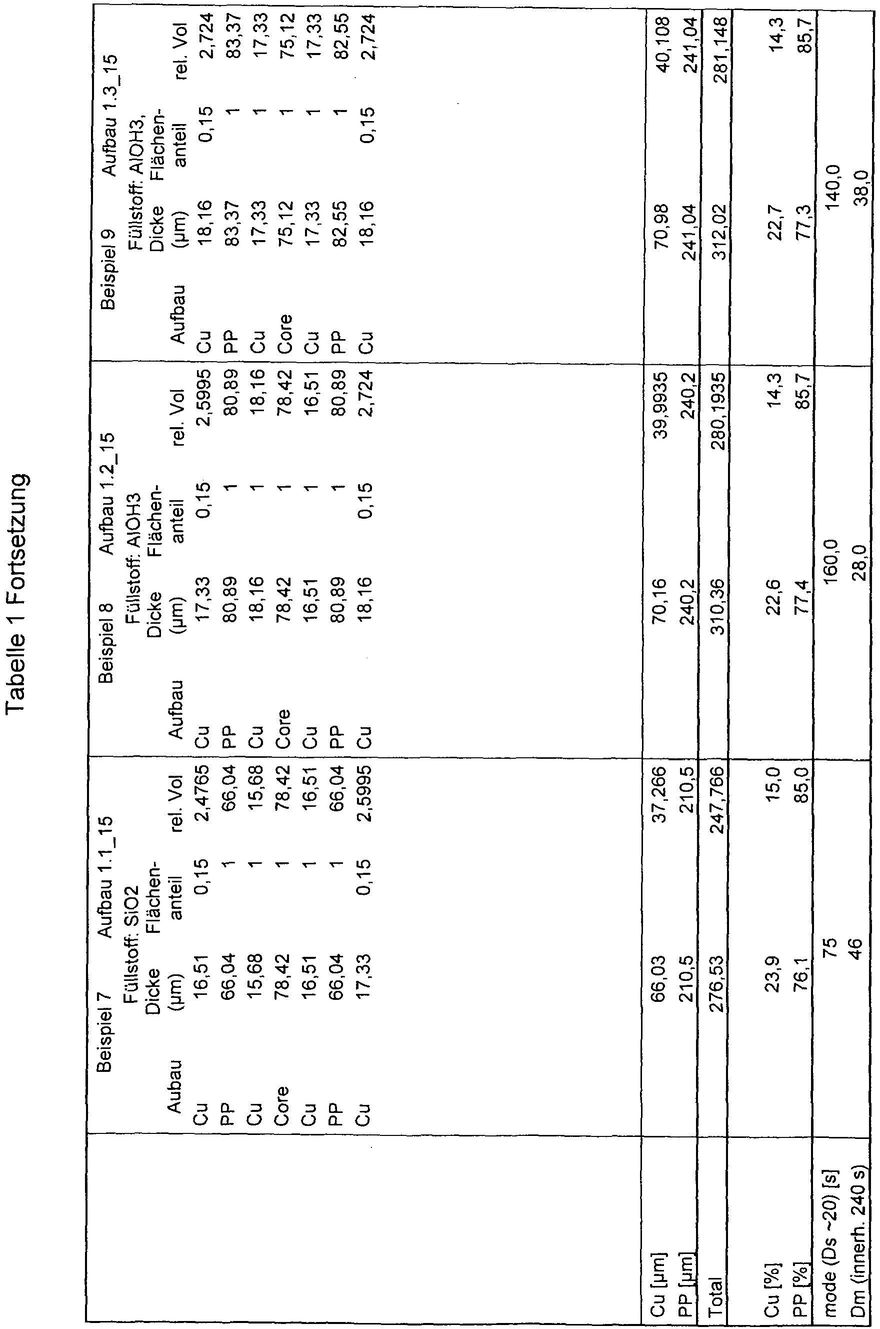

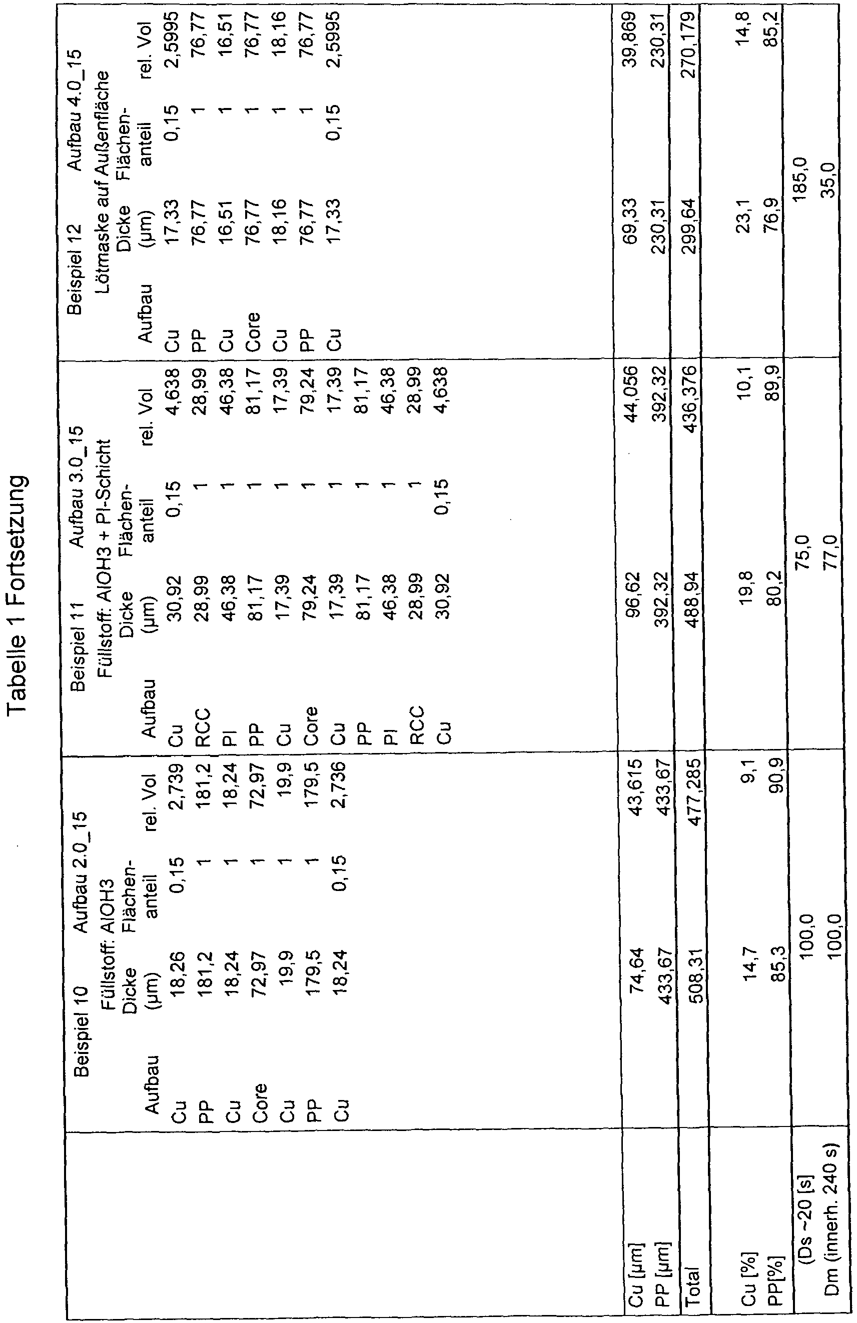

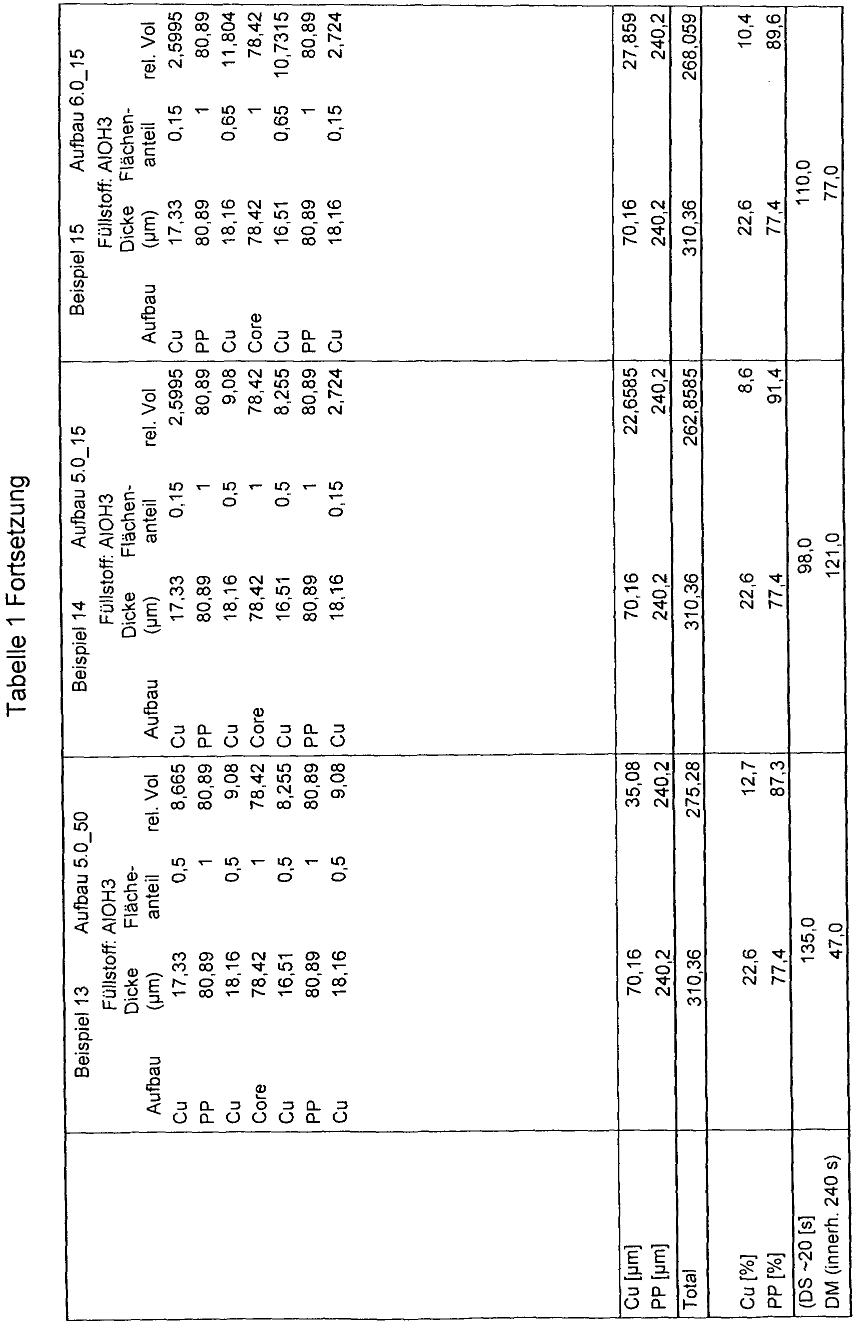

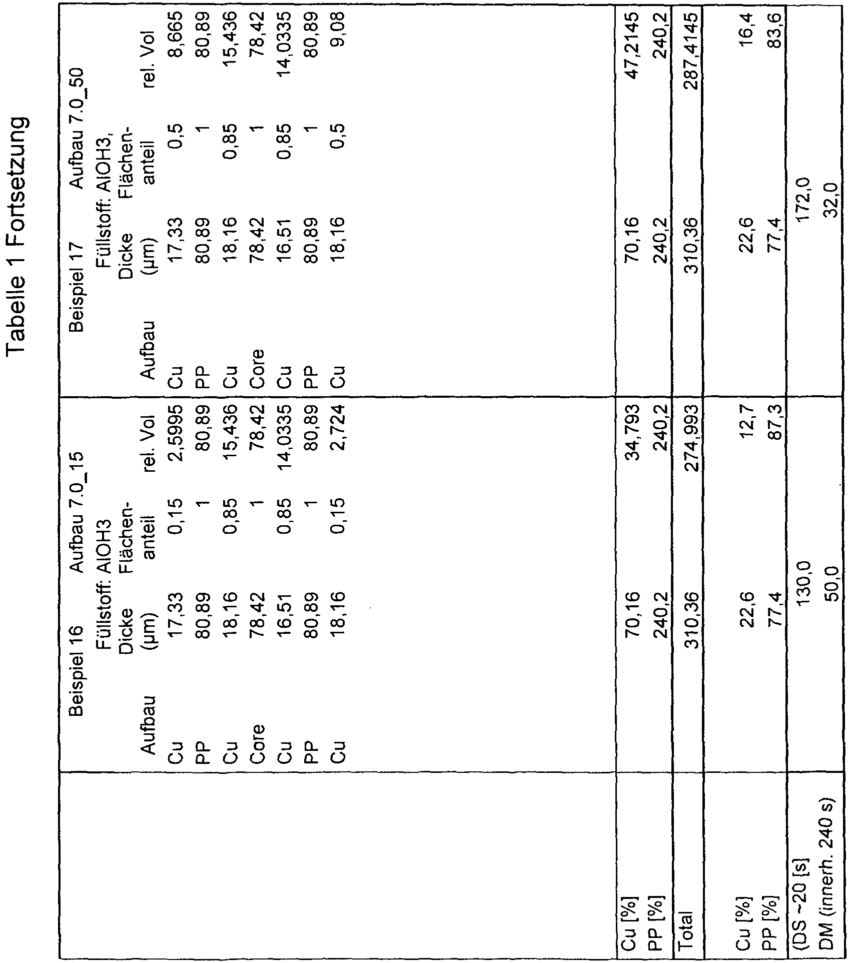

**Tabelle 2**

| | Vergleichsbeispiel 1 Aufbau SBE0954 | | | | Vergleichsbeispiel 2 Aufbau SOF1002 | | | | Vergleichsbeispiel 3 Aufbau STC5763 | | | |
|---|---|---|---|---|---|---|---|---|---|---|---|---|
| | Aufbau | Dicke (µm) | Flächenanteil | rel. Vol | Aufbau | Dicke (µm) | Flächenanteil | rel. Vol | Aufbau | Dicke (µm) | Flächenanteil | rel. Vol |
| | Cu | 5 | 0,3 | 1,5 | Cu | 5 | 0,7 | 3,5 | Cu | 5 | 0,2 | 1 |
| | PP | 200 | 1 | 200 | PP | 50 | 1 | 50 | PP | 50 | 1 | 50 |
| | Cu | 18 | 0,95 | 17,1 | Cu | 35 | 0,2 | 7 | Cu | 18 | 0,1 | 1,8 |
| | Core | 200 | 1 | 200 | Core | 250 | 1 | 250 | PP | 50 | 1 | 50 |
| | Cu | 18 | 0,4 | 7,2 | Cu | 35 | 0,4 | 14 | Cu | 34 | 0,9 | 30,6 |
| | PP | 150 | 1 | 150 | PP | 120 | 1 | 120 | Core | 1200 | 1 | 1200 |
| | PP | 200 | 1 | 200 | PP | 120 | 1 | 120 | Cu | 34 | 0,9 | 30,6 |
| | PP | 200 | 1 | 200 | Cu | 35 | 0,7 | 24,5 | PP | 50 | 1 | 50 |
| | PP | 150 | 1 | 150 | core | 100 | 1 | 100 | Cu | 18 | 0,2 | 3,6 |
| | Cu | 18 | 0,25 | 4,5 | Cu | 35 | 0,7 | 24,5 | PP | 50 | 1 | 50 |
| | core | 200 | 1 | 200 | PP | 120 | 1 | 120 | Cu | 5 | 0,3 | 1,5 |
| | Cu | 18 | 0,95 | 17,1 | PP | 120 | 1 | 120 | | | | |
| | PP | 200 | 1 | 200 | Cu | 35 | 0,5 | 17,5 | | | | |
| | Cu | 5 | 0,6 | 3 | care | 250 | 1 | 250 | | | | |
| | | | | | Cu | 35 | 0,2 | 7 | | | | |
| | | | | | PP | 50 | 1 | 50 | | | | |
| | | | | | Cu | 5 | 0,4 | 2 | | | | |
| Cu [µm] | | 82 | | 50,4 | | 220 | | 100 | | 114 | | 69,1 |
| PP [µm] | | 1500 | | 1500 | | 1180 | | 1180 | | 1400 | | 1400 |
| Total | | 1582 | | 1550,4 | | 1400 | | 1280 | | 1514 | | 1469,1 |
| Cu [%] | | 5,2 | | 3,3 | | 15,7 | | 7,8 | | 7,5 | | 4,7 |
| PP [%] | | 94,8 | | 96,7 | | 84,3 | | 92,2 | | 92,5 | | 95,3 |
| (DS ∼20 [s] | 90 | | | | 45 | | | | 105 | | | |
| Dm (innerh. 240 s) | 660 | | | | 660 | | | | 340 | | | |

Aus Tabelle 1 ist ersichtlich, daß bei einer Mehrzahl der angegebenen Beispiele Füllstoffe der jeweils angegebenen Art in wenigstens einer Lage aus nicht leitenden Materialien, insbesondere Dielektrikum, insbesondere Polypropylen (PP) enthalten ist.

Darüber hinaus ist für Beispiel 5 und 11 angegeben, daß eine zusätzliche Schicht bzw. Lage aus einem flammbeständigen Material, wie beispielsweise PI (Polyimid) vorgesehen ist.

Während für die Beispiele 1 bis 12 jeweils im Inneren die Schichten aus nicht brennbarem, leitendem Material, welches in den Ausführungsbeispielen jeweils als Cu (Kupfer) angegeben ist, im wesentlichen vollflächig mit einem Flächenanteil von 1 bzw. 100 % ausgebildet sind, ist für die Beispiele 13 bis 17 ersichtlich, daß auch mit einem Flächenanteil von wenigstens 50 % (0,5), insbesondere wenigstens 70 % die Anforderungen des eingangs erwähnten Smoke Density Tests eines Maximums an optischer Rauchdichte Dm von 200 innerhalb 240 Sekunden ohne weiteres erfüllt werden können.

Darüber hinaus ist für den Flächenanteil bzw. Oberflächenanteil der jeweils zum Äußeren gerichteten Schichten bzw. Lagen ersichtlich, daß bereits ab einem Flächenanteil bzw. Oberflächenanteil von 0,15 bzw. 15 % ebenfalls die Bedingungen des Smoke Density Tests erfüllt werden. Durch eine Erhöhung des Oberflächenanteils an den zum Äußeren gerichteten Lagen auf wenigstens 40 %, und insbesondere 50 % werden die Ergebnisse im Hinblick auf eine Rauchgasunterdrückung bzw. Rauchgasentwicklung durch Verringerung des Werts Dm innerhalb der vorgegebenen 240 Sekunden entsprechend verbessert.

Weiters ist aus Tabelle 1 ersichtlich, daß entsprechend gute Testwerte durch Verwendung von Schichtdicken für das nicht leitende Material, insbesondere Dielektrikum, von maximal 250 µm, insbesondere 150 µm erzielbar sind, wobei diese maximalen Dicken auch beispielsweise für den Aufbau von Beispiel 5 und Beispiel 11, wobei drei Schichten bzw. Lagen aus einem nicht leitenden Material aneinander anschließen, erfüllt bzw. eingehalten werden.

Bei einem Vergleich der Dicken insbesondere der Lagen aus nicht leitendem Material mit dem in den Vergleichsbeispielen gemäß Tabelle 2 verwendeten Aufbau wird unmittelbar ersichtlich, daß durch Verwendung von Schichten bzw. Lagen entsprechend geringer Dicke, welche insbesondere eine Dicke bzw. Gesamtdicke von 250 µm übersteigen, wie dies für die Vergleichsbeispiele 1 bis 3 mehrfach der Fall ist, die geforderten Grenzwerte für Dm nicht eingehalten werden können.

Weiters ist aus einem Vergleich der Strukturen bzw. Aufbauten gemäß Tabelle 1 und Tabelle 2 ersichtlich, daß bei Überschreitung einer maximalen Dicke für die gesamte, mehrlagige Leiterplatte von 1,25 mm, insbesondere 1 mm ebenfalls die Testanforderungen nicht erfüllt werden können.

Darüber hinaus ist erkennbar, daß zur Erfüllung der Testanforderungen der Volumsanteil an nicht brennbarem, leitendem Material, insbesondere Kupfer wenigstens 8 Vol.-% beträgt. Bei einer weiteren Erhöhung des Volumsanteils an nicht brennbarem, leitendem Material, insbesondere Kupfer, auf wenigstens 12 Vol.-% lassen sich die Testergebnisse weiter verbessern, wie dies beispielsweise aus den Beispielen 1, 2, 3, 5, 6, 7, 8, 9, 12, 13, 16 und 17 ersichtlich ist.

Darüber hinaus ist sowohl in Tabelle 1 als auch in Tabelle 2 die Zeit in Sekunden angegeben, welche für die unterschiedlichen Strukturen bzw. Aufbauten gemäß den Beispielen 1 bis 17 als auch den Vergleichsbeispielen 1, 2 und 3 erforderlich ist, um eine spezifische, optische Dichte an Rauchgas von 20 zu erreichen.

Bei einem Vergleich der einzelnen Ergebnisse ist hierbei ersichtlich, daß durch das raschere Erreichen eines Werts von Dm von 20 bei Verwendung von Strukturen bzw. Aufbauten gemäß den Vergleichsbeispielen 1 bis 3 ebenfalls die Testanforderungen für Dm in weiterer Folge nicht eingehalten bzw. erfüllt werden können.

Aus einem Vergleich der in Tabelle 1 angeführten Beispiele mit insbesondere im Inneren der mehrlagigen Leiterplatte 10 bzw. 20 angeordneten Schichten bzw. Lagen mit einem großen Oberflächenanteil bzw. Flächenanteil aus nicht brennbarem, leitendem Material im Gegensatz zu den in Tabelle 2 angeführten Vergleichsbeispielen, in welchen Aufbauten von insbesondere derzeit bekannten mehrlagigen Leiterplatten überprüft wurden, läßt sich somit erkennen, daß durch Einhalten der oben angegebenen Parameter die gewünschte Flammbeständigkeit bzw. die Reduzierung oder Minimierung einer Rauchgasentwicklung zur erfolgreichen Absolvierung eines eingangs erwähnten Smoke Density Tests erzielbar ist.

Im Zusammenhang mit den in den Beispielen 1 bis 12 angeführten, im wesentlichen vollflächigen Schichten bzw. Lagen aus nicht brennbarem, leitendem Material (Cu) insbesondere im Inneren der unterschiedlichen Strukturen bzw. Aufbauten wird angemerkt, daß in derartigen, im wesentlichen vollflächigen Schichten bzw. Lagen selbstverständlich, ähnlich wie dies in Fig. 2 dargestellt bzw. angedeutet ist, Durchbrechungen für eine Kontaktierung oder dgl. vorgesehen sein können. Da derartige Durchbrechungen üblicherweise einen vergleichsweise geringen Querschnitt bzw. Flächenanteil aufweisen, ergibt sich unverändert ein Prozentsatz von im wesentlichen bzw. nahezu 100 % für derartige innenliegende Schichten bzw. Lagen aus nicht brennbarem, leitendem Material, insbesondere Kupfer.

Derartige, im wesentlichen vollflächige Lagen können insbesondere für elektromagnetische Abschirmeffekte neben den Effekten einer verbesserten Flammbeständigkeit und Unterdrückung einer Rauchgasentwicklung zum Einsatz gelangen.

## Patentansprüche

1. Mehrlagige Leiterplatte, insbesondere flammbeständige und/oder Rauchgas unterdrückende mehrlagige Leiterplatte (10, 20), welche aus einer Mehrzahl von miteinander verbundenen Lagen (2, 3, 6, 7, 12, 13) aus nicht brennbarem, leitendem Material und Lagen (1, 4, 5, 11) aus nicht leitendem Material besteht, wobei jeweils zwei Lagen (2, 3, 6, 7, 12, 13) aus einem leitenden Material durch wenigstens eine Lage (1, 4, 5, 11) aus einem nicht leitenden Material getrennt sind, wobei auf zum Äußeren gewandten Lagen (6, 7) aus dem nicht brennbaren, leitenden Material jeweils zusätzlich eine Lötmaske (8, 9) vorgesehen ist und die Dicke der Lagen (2, 3, 6, 7, 12, 13) aus nicht brennbarem, leitendem Material geringer als die Dicke der wenigstens einen Lage (1, 4, 5, 11) aus nicht leitendem Material ist, wobei - zur Erfüllung von Testanforderungen für eine Rauchgasentwicklung insbesondere in der Luftfahrtindustrie, wonach bei von außen anliegenden erhöhten Temperaturen und/oder einem unmittelbaren Aussetzen an eine Flamme über einen Zeitraum von 240 s eine maximale spezifische optische Dichte (Dm) unter 200 zu erzielen ist - die Leiterplatte (10, 20) in ihrem Inneren wenigstens zwei Lagen (2, 3, 12) enthält, welche einen Oberflächenanteil von wenigstens 50 %, insbesondere wenigstens 70 % aus dem nicht brennbaren, leitenden Material aufweisen, die Leiterplatte an ihren zum Äußeren gewandten Oberflächen Lagen (6, 7, 13) enthält, welche jeweils einen Oberflächenanteil von wenigstens 15 %, insbesondere wenigstens 40 % aus dem nicht brennbaren, leitenden Material aufweisen, die Lagen (2, 3, 12) im Inneren der Leiterplatte (10, 20) aus dem nicht brennbaren, leitenden Material durch wenigstens eine Lage (1, 4, 5, 11) aus nicht leitendem Material, insbesondere einem Dielektrikum getrennt sind, welches eine Dicke von höchstens 250 µm, insbesondere höchstens 150 µm aufweist, und der Volumsanteil an Lagen (2, 3, 6, 7, 12, 13) aus dem nicht brennbaren, leitenden Material wenigstens 8 Vol.-%, insbesondere wenigstens 12 Vol.-% der mehrlagigen Leiterplatte (10, 20) beträgt.

2. Mehrlagige Leiterplatte nach Anspruch 1, **dadurch gekennzeichnet, dass** der Oberflächenanteil des nicht brennbaren, leitenden Materials der zum Äußeren gewandten Lagen (6, 7) größer als der Oberflächenanteil der Lötmaske (8, 9) ist.

3. Mehrlagige Leiterplatte nach Anspruch 1 oder 2, **dadurch gekennzeichnet, dass** Teilbereiche (15) aus nicht brennbarem, leitendem Material einzelner Lagen (2, 3, 12), welche jeweils durch wenigstens eine Lage (1, 11) aus nicht leitendem Material getrennt sind, in einer Draufsicht auf die mehrlagige Leiterplatte (20) zueinander versetzt und/oder insbesondere einander wenigstens teilweise überlappend ausgebildet bzw. angeordnet sind.

4. Mehrlagige Leiterplatte nach einem der Ansprüche 1 bis 3, **dadurch gekennzeichnet, dass** die Lage(n) (2, 3, 6, 7, 12, 13) aus dem nicht brennbaren, leitenden Material jeweils von einer Kupferschicht gebildet ist bzw. sind.

5. Mehrlagige Leiterplatte nach einem der Ansprüche 1 bis 4, **dadurch gekennzeichnet, dass** der (den) Lage(n) (1, 4, 5, 11) aus dem nicht leitenden Material flammbeständige und/oder Rauchgas unterdrückende Füllstoffe, wie beispielsweise Al(OH)₃,SiO₂ und dgl. zugesetzt sind und/oder eine Lage aus nicht leitendem Material durch eine flammhemmende Schicht, beispielsweise eine Polyimidschicht abgedeckt ist.

6. Mehrlagige Leiterplatte nach einem der Ansprüche 1 bis 5, **dadurch gekennzeichnet, dass** die Anzahl der Lagen (1, 4, 5, 11) aus nicht leitendem Material weniger als 7, insbesondere weniger als 5 beträgt.

7. Mehrlagige Leiterplatte nach einem der Ansprüche 1 bis 6, **dadurch gekennzeichnet, dass** die Gesamtdicke der mehrlagigen Leiterplatte (10, 20) höchstens 1,25 mm, insbesondere maximal 1 mm beträgt.

## Claims

1. A multilayer printed circuit board, more particularly a flame-retardant and/or smoke-suppressing multilayer printed circuit board or conductive plate (10, 20), consisting of a plurality of interconnected layers (2, 3, 6, 7, 12, 13) composed of incombustible, conductive material and layers (1, 4, 5, 11) composed of non-conductive material, wherein two layers (2, 3, 6, 7, 12, 13) composed of conductive material in each case are separated by at least one layer (1, 4, 5, 11) composed of non-conductive material, wherein a solder mask (8, 9) is each additionally provided on outwardly facing layers (6, 7) being composed of the incombustible, conductive material and the thickness of the layers (2, 3, 6, 7, 12, 13) composed of incombustible, conductive material is smaller than the thickness of the at least one layer (1, 4, 5, 11) composed of non-conductive material, wherein - for fulfilling test requirements for a development of smoke, in particular in the aircraft industry, according to which at externally applied elevated temperatures and/or a direct exposure to a flame for a time of 240 s a maximum specific optical density (Dm) of below 200 has to be achieved - the printed circuit board (10, 20) contains in its interior at least two layers (2, 3, 12) having a surface proportion of at least 50%, more particularly at least 70%, composed of the incombustible, conductive material, the printed circuit board, on its surfaces facing the outside, includes layers (6, 7, 13) each comprising a surface portion of at least 15%, particularly at least 40%, of the incombustible, conductive material, the layers (2, 3, 12) composed of the incombustible, conductive material in the interior of the printed circuit board (10, 20) are separated by at least one layer (1, 4, 5, 11) composed of a non-conductive material, particularly dielectric, having a maximum thickness of 250 µm and, in particular, 150 µm and the volume portion of layers (2, 3, 6, 7, 12, 13) composed of the incombustible, conductive material is at least 8% by volume, in particular at least 12% by volume, of the multilayer printed circuit board (10, 20).

2. A multilayer printed circuit board according to claim 1, **characterized in that** the surface portion of the incombustible, conductive material of the outwardly facing layers (6, 7) is larger than the surface portion of the solder mask (8, 9).

3. A multilayer printed circuit board according to any one of claims 1 to 2, **characterized in that** partial regions (15) of incombustible, conductive material of individual layers (2, 3, 12), which are each separated by at least one layer (1, 11) of non-conductive material, are formed or arranged in a mutually offset and/or, in particular, at least partially overlapping manner, seen in a top view of the multilayer printed circuit board (20).

4. A multilayer printed circuit board according to any one of claims 1 to 3, **characterized in that** the layer(s) (2, 3, 6, 7, 12, 13) composed of the incombustible, conductive material is/are each formed by a copper layer.

5. A multilayer printed circuit board according to any one of claims 1 to 4, **characterized in that** flame-retardant and/or smoke-suppressing fillers such as, e.g., Al(OH)₃, SiO₂ and the like are added to the layer(s) (1, 4, 5, 11) composed of the non-conductive material, and/or a layer composed of a non-conductive material is covered by a flame-retardant layer, e.g. a polyimide layer.

6. A multilayer printed circuit board according to any one of claims 1 to 5, **characterized in that** the number of layers (1, 4, 4, 11) composed of non-conductive material is less than 7 and, in particular, less than 5.

7. A multilayer printed circuit board according to any one of claims 1 to 6, **characterized in that** the maximum overall thickness of the multilayer printed circuit board (10, 20) is 1.25 mm and, in particular, 1 mm.

## Revendications

1. Plaque conductrice multicouche, en particulier plaque conductrice multicouche (10, 20) résistante au feu et/ou atténuant les fumées, laquelle se compose d'une pluralité de couches (2, 3, 6, 7, 12, 13) reliées les unes aux autres en matériau conducteur non inflammable et de couches (1, 4, 5, 11) en matériau non conducteur, dans laquelle respectivement deux couches (2, 3, 6, 7, 12, 13) en un matériau conducteur sont séparées par au moins une couche (1, 4, 5, 11) en un matériau non conducteur, dans laquelle respectivement en plus un masque de brasage (8, 9) est prévu sur des couches (6, 7) tournées vers l'extérieur en matériau conducteur non inflammable et l'épaisseur des couches (2, 3, 6, 7, 12, 13) en matériau conducteur non inflammable est inférieure à l'épaisseur de l'au moins une couche (1, 4, 5, 11) en matériau non conducteur, dans laquelle - pour la satisfaction d'exigences d'essai pour un dégagement de fumées en particulier dans l'industrie aéronautique, ce par quoi dans le cas de températures accrues appliquées de l'extérieur et/ou d'une exposition directe à une flamme sur une période de 240 s, une épaisseur optique spécifique maximum (Dm) inférieure à 200 doit être atteinte - la plaque conductrice (10, 20) contient à l'intérieur de celle-ci au moins deux couches (2, 3, 12), lesquelles présentent une part de surface d'au moins 50 %, en particulier d'au moins 70 % en matériau conducteur non inflammable, la plaque conductrice contient au niveau de ses surfaces tournées vers l'extérieur, des couches (6, 7, 13), lesquelles présentent respectivement une part de surface d'au moins 15 %, en particulier d'au moins 40 % en matériau conducteur non inflammable, les couches (2, 3, 12) à l'intérieur de la plaque conductrice (10, 20) en matériau conducteur non inflammable sont séparées par au moins une couche (1, 4, 5, 11) en matériau non conducteur, en particulier un diélectrique, lequel présente une épaisseur de maximum 250 µm, en particulier de maximum 150 µm, et la part de volume de couches (2, 3, 6, 7, 12, 13) en matériau conducteur non inflammable est au moins 8 % vol., en particulier au moins 12 % vol. de la plaque conductrice multicouche (10, 20).

2. Plaque conductrice multicouche selon la revendication 1, **caractérisée en ce que** la part de surface du matériau conducteur non inflammable des couches (6, 7) tournées vers l'extérieur est supérieure à la part de surface du masque de brasage (8, 9).

3. Plaque conductrice multicouche selon la revendication 1 ou 2, **caractérisée en ce que** des zones partielles (15) en matériau conducteur non inflammable de différentes couches (2, 3, 12), lesquelles sont séparées respectivement par au moins une couche (1, 11) en matériau non conducteur, sont décalées les unes par rapport aux autres dans une vue de dessus sur la plaque conductrice multicouche (20) et/ou en particulier réalisées ou agencées se recouvrant au moins en partie les unes les autres.

4. Plaque conductrice multicouche selon l'une quelconque des revendications 1 à 3, **caractérisée en ce que** la (les) couche(s) (2, 3, 6, 7, 12, 13) en matériau conducteur non inflammable est ou sont formée(s) respectivement d'une couche de cuivre.

5. Plaque conductrice multicouche selon l'une quelconque des revendications 1 à 4, **caractérisée en ce que** des charges résistantes au feu et/ou atténuant les fumées, comme par exemple Al(OH)₃, SiO₂ et similaires sont ajoutées à la (aux) couche(s) (1, 4, 5, 11) en matériau non conducteur et/ou une couche de matériau non conducteur est recouverte par une couche ignifuge, par exemple une couche de polyimide.

6. Plaque conductrice multicouche selon l'une quelconque des revendications 1 à 5, **caractérisée en ce que** le nombre de couches (1, 4, 5, 11) en matériau non conducteur est inférieur à 7, en particulier inférieur à 5.

7. Plaque conductrice multicouche selon l'une quelconque des revendications 1 à 6, **caractérisée en ce que** l'épaisseur totale de la plaque conductrice multicouche (10, 20) est de maximum 1,25 mm, en particulier de maximum 1 mm.
